# EUROPÄISCHE PATENTSCHRIFT

(11) **EP 2 640 175 B1**
(45) Veröffentlichungstag und Bekanntmachung des Hinweises auf die Patenterteilung: **12.07.2017**
(21) Anmeldenummer: 12159046.7
(22) Anmeldetag: 12.03.2012
(51) Int. Cl.: H05K 7/20, H05K 7/14

(54) **Baugruppe für ein modulares Automatisierungsgerät**
Assembly for a modular automation device
Bloc destiné à un appareil d'automatisation modulaire

(43) Veröffentlichungstag der Anmeldung: 18.09.2013
(73) Patentinhaber: Siemens Aktiengesellschaft, 80333 München (DE)
(72) Erfinder: Kort, Valentin, 76829 Landau (DE); Cyron, Michael, 76187 Karlsruhe (DE)

(56) Entgegenhaltungen:
- DE-A1- 10 147 946
- JP-A- 2001 221 486
- US-A- 5 214 621
- US-A1- 2002 080 852
- US-A1- 2010 290 183

## Beschreibung

Die Erfindung betrifft eine Baugruppe für ein modulares Automatisierungsgerät, in welcher parallel zu einer Seitenwand einer Gehäusekapsel der Baugruppe eine SMD-Leiterplatte angeordnet ist, welche einen SMD-Sensor zur Erfassung der Temperatur der Zuluft in der Gehäusekapsel aufweist, wobei die Zuluft durch Lufteintrittsöffnungen der Gehäusekapsel über die SMD-Leiterplatte und schließlich durch Luftaustrittsöffnungen der Gehäusekapsel strömt. Ferner betrifft die Erfindung eine Leiterplatte für eine solche Baugruppe.

Derartige Baugruppen sind aus dem Siemens-Katalog ST 70, Kapitel 5, Ausgabe 2011 bekannt. Die auf einen Träger montierbaren Baugruppen sind Bestandteil eines modularen Automatisierungsgerätes und weisen jeweils innerhalb einer Gehäusekapsel eine mit elektrischen und elektronischen Bauteilen versehene SMD-Leiterplatte auf. Die Entwärmung dieser Bauteile erfolgt im Wesentlichen durch Konvektion in der Art und Weise, dass Luft durch eine Öffnung auf der Unterseite der Gehäusekapsel, über die Bauteile und schließlich durch eine Öffnung auf der Oberseite der Gehäusekapsel strömt, wobei die durch das Gehäuse strömende Luft den Bauteilen Wärme entzieht. Mittels eines auf der SMD-Leiterplatte angeordneten SMD-Sensors wird die Temperatur der Zuluft erfasst, wobei für den Fall, dass die Temperatur einen Schwellwert erreicht oder übersteigt, eine Temperaturüberwachungseinheit einem Anwender einen Fehler anzeigt. Aufgrund der SMD-Bauweise wird zwar der Platzbedarf der Bauelemente auf der Leiterplatte verringert, nachteilig ist allerdings, dass die Verlustwärme der Baugruppe den SMD-Sensor im Hinblick auf eine genaue Erfassung der Zulufttemperatur störend beeinflusst. Beispielsweise verfälschen auf der Leiterplatte angeordnete Wärmequellen in Form von Transformatoren oder Feldeffekttransistoren das Messergebnis des SMD-Sensors, d. h. die Temperatur der Zuluft kann nicht genau erfasst werden.

DE 101 47 946 A1 offenbart eine Baugruppe eines Automatisierungsgerätes, die eine Leiterplatte mit einem Sensor zur Ermittlung eines Umgebungseinflusses aufweist.

US 2010/0290183 A1 beschreibt eine Leiterplatte mit einem Temperatursensor. Zur Isolierung des Sensors vor der Wärme, die mittels integrierten Schaltungen der Leiterplatte erzeugt wird, ist eine Öffnung in der Leiterplatte vorgesehen.

Aus der US 2002/0080852 A1 ist eine Leiterplatte mit einem thermisch isolierten Bereich bekannt. Dieser Bereich trennt einen Temperatursensor von einem wärmeerzeugenden Bauteil.

JP 2001 221486 A zeigt eine Leiterplatte mit Schlitzen, die eine Ausbreitung der Wärme von einer Steuerschaltung zu einem Temperatursensor vermindern.

Der Erfindung liegt daher die Aufgabe zugrunde, eine Baugruppe der eingangs genannten Art zu schaffen, welche eine genauere Erfassung der Zulufttemperatur ermöglicht. Darüber hinaus ist eine Leiterplatte anzugeben, welche für einen Einsatz in einer derartigen Baugruppe geeignet ist.

Diese Aufgabe wird im Hinblick auf die Baugruppe durch die im kennzeichnenden Teil des Anspruchs 1, bezüglich der Leiterplatte durch die im kennzeichnenden Teil des Anspruchs 2 angegebenen Maßnahmen gelöst.

Vorteilhaft ist, dass aufgrund der Aussparungen und der besonderen Anordnung des Kühlkörpers die zu erfassende Temperatur besser an die Zulufttemperatur bzw. Temperatur außerhalb der Gehäusekapsel angepasst wird. Der Kühlkörper erhöht den Wärmewiderstand von den Wärmequellen der Leiterplatte, beispielsweise Wärmequellen in Form von FETs oder Trafos, in Richtung SMD-Sensor und kühlt die Leiterplatten-Temperatur im Bereich des Sensors derart, dass die Temperatur der Leiterplatte sich der Zulufttemperatur besser "annähert".

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
Figur 1 einen Ausschnitt einer SMD-Leiterplatte und
Figur 2 eine Baugruppe eines Automatisierungsgerätes.

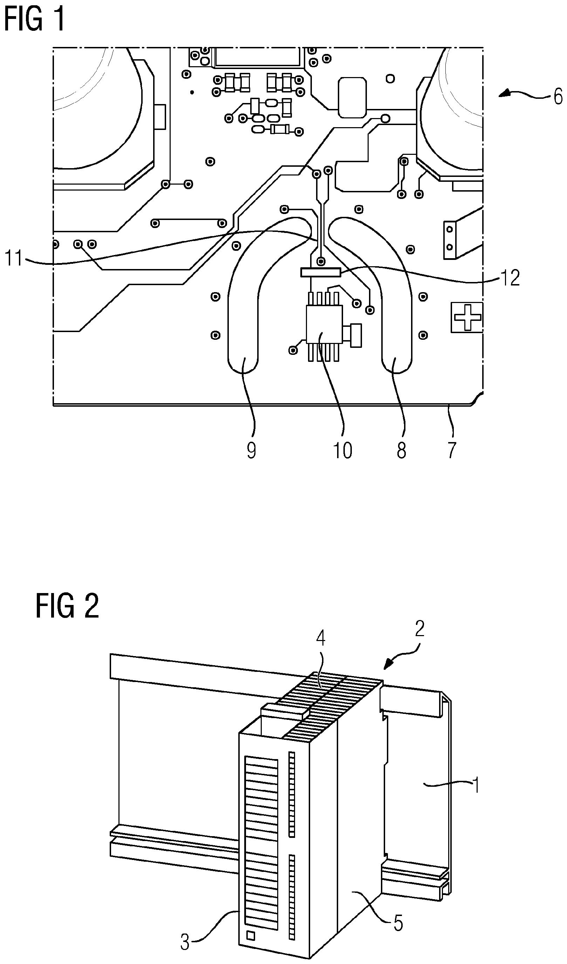

Es wird zunächst auf Figur 2 verwiesen, in welcher eine an sich bekannte, auf einem Träger 1 angeordnete Baugruppe 2 dargestellt ist. Die Entwärmung erfolgt im Wesentlichen durch Konvektion in der Art und Weise, dass Zuluft durch Öffnungen (Lufteintrittsöffnungen) auf der Unterseite einer Gehäusekapsel 3 über die elektrischen und elektronischen Bauteile der Baugruppe und schließlich durch eine Öffnung 4 (Luftaustrittsöffnungen) auf der Oberseite der Gehäusekapsel 2 strömt, wobei die durch die Gehäusekapsel 2 strömende Luft den auf einer SMD-Leiterplatte angeordneten bzw. montierten Bauteilen Wärme entzieht. Die SMD-Leiterplatte ist in der Gehäusekapsel 3 parallel zur Seitenwand 5 der Gehäusekapsel 3 positioniert bzw. angeordnet und weist einen SMD-Sensor zur Erfassung der Zulufttemperatur auf.

Um zu vermeiden, dass auf der Leiterplatte angeordnete Wärmequellen das Messergebnis des SMD-Sensors verfälschen, ist dieser SMD-Sensor zwischen einer ersten und einer zweiten Aussparung der SMD-Leiterplatte und zwischen einem Kühlkörper und einer zur Lufteintrittsöffnung bzw. zur Unterseite der Gehäusekapsel 3 gerichteten Kante der SMD-Leiterplatte angeordnet.

Zur näheren Erläuterung wird dazu im Folgenden auf Figur 1 verwiesen, in welcher ein Ausschnitt einer SMD-Leiterplatte 6 dargestellt ist. An einer unteren Kante 7 dieser SMD-Leiterplatte 6 ist zwischen einer Aussparung 8 und einer weiteren Aussparung 9 ein SMD-Sensor 10 angeordnet, welcher mit zwischen diesen Aussparungen 8, 9 geführten Leiterbahnen 11 kontaktiert und über diese Leiterbahnen 11 beispielsweise mit einer auf der Leiterplatte 6 angeordneten Temperaturüberwachungseinheit verbunden ist. Ferner ist der Sensor 10 zwischen der Kante 7 und einem SMD-Kühlkörper 12 angeordnet, welcher zusammen mit den Aussparungen 8, 9 den Einfluss der Wärmequellen der Leiterplatte 6 im Hinblick auf eine Wärmeeinkopplung in Richtung des Sensors 10 verringert. Mit anderen Worten: Die Aussparungen 8, 9 und der Kühlkörper 12 bewirken eine "Abschirmung" der Wärme der Leiterplatte 6 vom Sensor 10, wobei ferner durch die Positionierung des Sensors 10 im Bereich der zur Lufteintrittsöffnung gerichteten Kante 7 der Leiterplatte 6 die Zuluft quasi direkt zum Sensor 10 geführt wird.

Die Erfindung lässt sich damit wie folgt zusammenfassen:
Eine Baugruppe für ein modulares Automatisierungsgerät, in welcher parallel zu einer Seitenwand 5 einer Gehäusekapsel 3 der Baugruppe 2 eine SMD-Leiterplatte 6 angeordnet ist, welche einen SMD-Sensor 10 zur Erfassung der Temperatur der Zuluft in der Gehäusekapsel 3 aufweist, wobei die Zuluft durch Lufteintrittsöffnungen der Gehäusekapsel 3, über die SMD-Leiterplatte 6 und schließlich durch Luftaustrittsöffnungen 4 der Gehäusekapsel 3 strömt, zeichnet sich dadurch aus, dass der SMD-Sensor 6 zwischen einer ersten und einer zweiten Aussparung 8, 9 der SMD-Leiterplatte 6 und zwischen einem Kühlkörper 12 und einer zur Lufteintrittsöffnung der Gehäusekapsel 3 gerichteten Kante 7 der SMD-Leiterplatte 6 angeordnet ist, wobei der SMD-Sensor 10 mit zwischen der ersten und der zweiten Aussparung 8, 9 geführten Leiterbahnen 11 kontaktiert. Mittels derartiger Maßnahmen wird eine genauere Erfassung der Zulufttemperatur ermöglicht.

## Patentansprüche

1. Baugruppe für ein modulares Automatisierungsgerät, in welcher parallel zu einer Seitenwand (5) einer Gehäusekapsel (3) der Baugruppe (2) eine SMD-Leiterplatte (6) angeordnet ist, welche einen SMD-Sensor (10) zur Erfassung der Temperatur der Zuluft in der Gehäusekapsel (3) aufweist, wobei die Zuluft durch Lufteintrittsöffnungen der Gehäusekapsel (3) über die SMD-Leiterplatte (6) und schließlich durch Luftaustrittsöffnungen (4) der Gehäusekapsel (3) strömt, **dadurch gekennzeichnet, dass** der SMD-Sensor (6) zwischen einer ersten und einer zweiten Aussparung (8, 9) der SMD-Leiterplatte (6) und zwischen einem Kühlkörper (12) und einer zur Lufteintrittsöffnung der Gehäusekapsel (3) gerichteten Kante (7) der SMD-Leiterplatte (6) angeordnet ist, wobei der SMD-Sensor (10) mit zwischen der ersten und der zweiten Aussparung (8, 9) geführten Leiterbahnen (11) kontaktiert.

2. SMD-Leiterplatte für eine Baugruppe nach Anspruch 1, wobei die SMD-Leiterplatte (6) einen SMD-Sensor (10) zur Erfassung der Temperatur der Zuluft in einer Gehäusekapsel (3) der Baugruppe (2) aufweist, **dadurch gekennzeichnet, dass** der SMD-Sensor (10) zwischen einer ersten und einer zweiten Aussparung (8, 9) der SMD-Leiterplatte (6) und zwischen einem Kühlkörper (12) und einer Kante (7) der SMD-Leiterplatte (6) angeordnet ist, wobei der SMD-Sensor (10) mit zwischen der ersten und der zweiten Aussparung (8, 9) geführten Leiterbahnen (11) kontaktiert.

## Claims

1. Assembly for a modular automation device, in which an SMD circuit board (6) is arranged in parallel to a side wall (5) of a housing capsule (3) of the assembly (2), which has an SMD sensor (10) for detecting the temperature of the supply air in the housing capsule (3), wherein the supply air flows through air inlet openings in the housing capsule (3) via the SMD circuit board (6) and finally through air outlet openings (4) in the housing capsule (3), **characterised in that** the SMD sensor (6) is arranged between a first and a second recess (8, 9) of the SMD circuit board (6) and between a cooling element (12) and an edge (7) of the SMD circuit board (6) directed toward the air inlet opening of the housing capsule (3), wherein the SMD sensor (10) is in contact with conductor paths (11) guided between the first and second recess (8, 9).

2. SMD circuit board for an assembly according to claim 1, wherein the SMD circuit board (6) has an SMD sensor (10) for detecting the temperature of the supply air in a housing capsule (3) of the assembly (2), **characterised in that** the SMD sensor (10) is arranged between a first and a second recess (8, 9) of the SMD circuit board (6) and between a cooling element (12) and an edge (7) of the SMD circuit board (6), wherein the SMD sensor (10) is in contact with conductor paths (11) guided between the first and the second recess (8, 9).

## Revendications

1. Module pour un appareil d'automatisation modulaire, dans lequel, parallèlement à une paroi (5) latérale d'un blindage (3) de boîtier du module (2), est montée une plaquette (6) circuit imprimé SMD, qui a un capteur (10) SMD de détection de la température de l'air entrant dans le blindage (3) du boîtier, l'air entrant passant, par des ouvertures d'entrée d'air du blindage (3) du boîtier, sur la plaquette (6) à circuit imprimé SMD et, enfin, par des ouvertures (4) de sortie d'air du blindage (3) du boîtier, **caractérisé en ce que** le capteur (6) SMD est monté entre un premier et un deuxième évidements (8, 9) de la plaquette (6) à circuit imprimé SMD et entre un dissipateur (12) de chaleur et un bord (7), dirigé vers l'ouverture d'entrée d'air du blindage (3) du boîtier, de la plaquette (6) à circuit imprimé SMD, le capteur (10) SMD étant mis en contact avec des pistes (11) conductrices passant entre le premier et le deuxième évidements (8, 9).

2. Plaquette à circuit imprimé SMD pour un module suivant la revendication 1, dans laquelle la plaquette (6) à circuit imprimé SMD a un capteur (10) SMD de détection de la température de l'air entrant dans un blindage (3) de boîtier du module (2), **caractérisée en ce que** le capteur (6) SMD est monté entre un premier et un deuxième évidements (8, 9) de la plaquette (6) à circuit imprimé SMD et entre un dissipateur (12) de chaleur et un bord (7), dirigé vers l'ouverture d'entrée d'air du blindage (3) du boîtier, de la plaquette (6) à circuit imprimé SMD, le capteur (10) SMD étant mis en contact avec des pistes (11) conductrices passant entre le premier et le deuxième évidements (8, 9).
